# EUROPEAN PATENT SPECIFICATION

(11) **EP 4 622 052 B1**
(45) Date of publication and mention of the grant of the patent: **14.10.2026**
(21) Application number: 25193543.3
(22) Date of filing: 02.11.2022
(51) Int. Cl.: G01R 31/367, G01R 31/36, G01R 31/392, G01R 31/3842, G01R 31/52, H02J 7/00

(54) **APPARATUS AND METHOD FOR MANAGING OCV-SOC PROFILE OF BATTERY**
VORRICHTUNG UND VERFAHREN ZUR VERWALTUNG DES OCV-SOC-PROFILS EINER BATTERIE
APPAREIL ET PROCÉDÉ DE GESTION DE PROFIL OCV-SOC DE BATTERIE

(30) Priority: 02.11.2021 KR 20210149216
(43) Date of publication of application: 24.09.2025
(62) Document number(s) of the earlier application(s) in accordance with Art. 76 EPC: 22890380.3 / 4 296 699
(73) Proprietor: LG Energy Solution, Ltd., Seoul 07335 (KR)
(72) Inventor: LEE, Hyun-Chul, 34122 DAEJEON (KR); KIM, Seung-Hyun, 34122 DAEJEON (KR); KIM, An-Soo, 34122 DAEJEON (KR); SHIN, Chae Bin, 34122 DAEJEON (KR)
(74) Representative: Plasseraud IP

(56) References cited:
- EP-B1- 2 527 855
- DE-A1- 102010 019 128

## Description

### TECHNICAL FIELD

The present disclosure relates to an apparatus and method for managing an Open Circuit Voltage (OCV)-State Of Charge (SOC) profile of a battery, and more particularly, to an apparatus and method for managing an adaptive change of an OCV-SOC profile of a battery according to the degree of degradation of the battery.

The present application claims priority to Korean Patent Application No. 10-2021-0149216 filed on November 2, 2021 in the Republic of Korea.

### BACKGROUND ART

As batteries degrade, their characteristics such as resistance or capacity change. When the characteristics of batteries change, it is necessary to change Open Circuit Voltage (OCV)-State Of Charge (SOC) profiles that are the basis of SOC estimation.

The OCV-SOC profile is a curve showing one-to-one correspondence between SOC and OCV on the X-Y coordinate system. In the X-Y coordinate system, X axis indicates SOC and Y axis indicates OCV. The OCV-SOC profile defines the upper limit of the battery charge voltage and the lower limit of the discharge voltage. Additionally, the OCV-SOC profile provides criteria for determining SOC from OCV, or on the contrary, determining OCV from SOC.

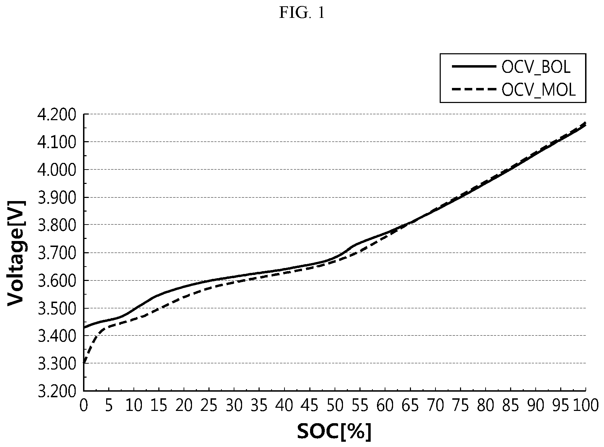

FIG. 1 is a diagram showing an example of the OCV-SOC profile of the battery at Beginning Of Life (BOL) and the OCV-SOC profile of the battery at Middle Of Life (MOL). The BOL status refers to a condition of the undegraded battery, and the MOL status refers to a condition of the degraded battery by repeated charging/discharging. The OCV-SOC profile at MOL as shown is a profile when the capacity of the battery is 10% lower than that of BOL.

Referring to FIG. 1, when the battery at BOL is charged and discharged, the OCV range is 3.450V to 4.157V (hereinafter, BOL OCV range). Additionally, when the battery at MOL is charged and discharged, the OCV range is 3.3V to 4.158V (hereinafter, MOL OCV range).

A battery management apparatus replaces the current OCV-SOC profile with the OCV-SOC profile at MOL when the capacity of the battery is lower than the capacity at BOL by the threshold. It is because it is necessary to replace the OCV-SOC profile as the battery capacity degrades in order to safely control the charge/discharge of the battery.

In an example, when the capacity of the battery is at least 10% lower than the capacity at BOL, the battery management apparatus changes the OCV-SOC profile from the solid line profile to the dashed line profile.

The MOL OCV range has a larger upper limit and a smaller lower limit than the BOL OCV range. Accordingly, when the capacity of the battery is measured during the charging or discharging of the battery in the MOL OCV range, the capacity is lower than the BOL capacity, and the reduction in capacity is less than 10% (for example, 8%). It is because the OCV-SOC profile changes as the capacity of the battery decreases, but the OCV range used to calculate the capacity is expanded a little bit, and with the expansion of the OCV range, the available capacity increases a little bit as much.

When simply changing the OCV-SOC profile according to the reduction in battery capacity as conventionally, in the above example, the OCV-SOC profile changes from the dashed line profile to the solid line profile again. The reduction in capacity measured in the MOL OCV range with the expanded upper and lower limits does not meet the change condition (i.e., the reduction in capacity is 10% or more) of the OCV-SOC profile, and thus the OCV-OCV profile returns to the profile at BOL.

Additionally, when the OCV-SOC profile returns to the profile at BOL, the OCV range is reduced a little bit to the BOL OCV range, and the capacity measured in the BOL OCV range decreases again by the threshold (10%). Accordingly, the battery management apparatus changes the OCV-SOC profile from the solid line profile to the dashed line profile again. Additionally, after the change of the OCV-SOC profile, the reduction in capacity measured in the MOL OCV range with the expanded upper and lower limits is less than the threshold (for example 8%), and then the battery management apparatus changes the OCV-SOC profile again from the dashed line profile to the solid line profile, causing repeated profile switching.

The repeated switching of the OCV-SOC profile degrades the safety and reliability of battery control, so there is a need for a new approach to manage the change in the OCV-SOC profile. EP2527855 B1 and DE 10 2010 019128 A1 relate to determining the current capacity of a battery on the basis of variations in OCV-SOC curves.

### DISCLOSURE

### Technical Problem

The present disclosure is designed under the above-described background, and therefore the present disclosure is directed to providing an apparatus and method for managing an Open Circuit Voltage (OCV)-State Of Charge (SOC) profile of a battery by newly establishing profile change criteria in the management of changes of the OCV-SOC profile as the battery capacity degrades in order to solve the repeated switching problem of the OCV-SOC profile.

The present disclosure is further directed to providing a system or an electric vehicle comprising an apparatus for managing an OCV-SOC profile of a battery.

### Technical Solution

To solve the above-described technical problem, an apparatus according to claim 1 is provided in a first aspect.

To solve the above-described technical problem, a method according to claim 7 is provided in a second aspect.

The technical problem of the present disclosure may be also solved by a system and an electric vehicle including the above-described apparatus for managing an OCV-SOC profile of a battery.

### Advantageous Effects

According to the present disclosure, it is possible to solve the repeated switching problem of the Open Circuit Voltage (OCV)-State Of Charge (SOC) profile referenced when controlling the battery by newly establishing the profile change criteria in the change of the OCV-SOC profile as the battery capacity degrades. Accordingly, it is possible to control the charge/discharge of the battery with safety and reliability according to the OCV-SOC profile to suit battery capacity fading.

### DESCRIPTION OF DRAWINGS

The accompanying drawings illustrate an exemplary embodiment of the present disclosure, and together with the following detailed description, serve to provide a further understanding of the technical aspect of the present disclosure, and thus the present disclosure should not be construed as being limited to the drawings.
FIG. 1 is a diagram showing an example of an Open Circuit Voltage (OCV)-State Of Charge (SOC) profile (solid line) of a battery at Beginning Of Life (BOL) and an OCV-SOC profile (dashed line) of a battery at Middle Of Life (MOL).
FIG. 2 is a schematic diagram of an apparatus for managing an OCV-SOC profile of a battery according to an embodiment of the present disclosure.
FIG. 3 is a diagram showing an example of a plurality of OCV-SOC profiles stored in a storage means according to an embodiment of the present disclosure.
FIG. 4 is a flowchart of a method for managing an OCV-SOC profile of a battery according to an embodiment of the present disclosure.

### BEST MODE

Hereinafter, an exemplary embodiment of the present disclosure will be described with reference to the accompanying drawings. Prior to the description, it should be understood that the terms or words used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation. Therefore, the embodiments described herein and the illustrations in the drawings are just an exemplary embodiment of the present disclosure and do not fully describe the technical aspect of the present disclosure, so it should be understood that a variety of other equivalents and modifications could have been made thereto at the time of filing the patent application.

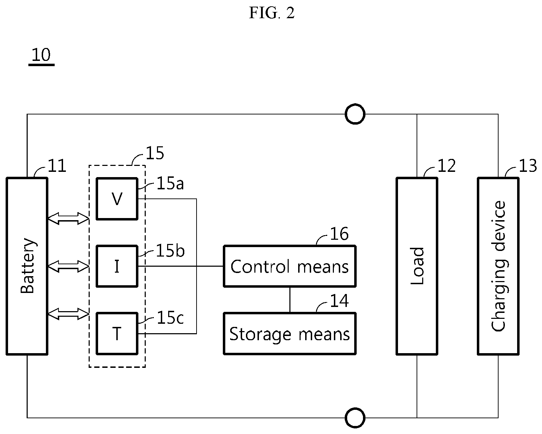

FIG. 2 is a diagram showing a schematic configuration of an apparatus 10 for managing an Open Circuit Voltage (OCV)-State Of Charge (SOC) profile of a battery 11 according to an embodiment of the present disclosure.

Referring to FIG. 2, the apparatus 10 for managing the OCV-SOC profile of the battery 11 manages the OCV-SOC profile used to control the operation of the battery 11. The operation of the battery 11 is charging or discharging of the battery 11. The OCV-SOC profile defines a one-to-one relationship between OCV and SOC as described in the prior art. The battery 11 may be charged or discharged in the OCV range of the OCV-SOC profile.

The battery 11 may be a lithium secondary battery, and the present disclosure is not limited by the type of the battery. Accordingly, the battery 11 may include any type of secondary battery that can be repeatedly recharged. The battery 11 includes at least one unit cell. The unit cell may be a pouch cell, a cylindrical cell or a prismatic cell. When the battery 11 includes a plurality of unit cells, the unit cells may be connected in series and/or in parallel.

In an embodiment of the present disclosure, it is assumed that the battery 11 includes one unit cell or the plurality of unit cells connected in series and/or in parallel. However, the present disclosure is not limited by the number of unit cells and the electrical connection relationship between the unit cells.

The battery 11 may supply discharge power to a load 12. The load 12 refers to a variety of devices that are supplied with power from the battery 11. The load 12 may be a motor of an electric vehicle, an electric or electronic device connected to an electrical grid, a power conversion device or the like. The battery 11 may be charged by a charging device 13. The charging device 13 may be a charging station of an electric vehicle or a Power Conversion System (PCS) of an energy storage system. Obviously, the present disclosure is not limited by the type of the load 12 or the charging device 13.

Preferably, the apparatus 10 may include a storage means 14 to store a plurality of OCV-SOC profiles having an overlapping zone in which the OCV-SOC profiles locally overlap in a preset SOC range.

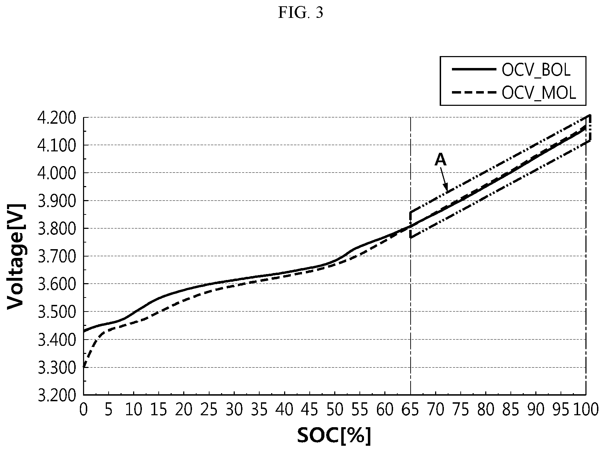

FIG. 3 is a diagram showing an example of the plurality of OCV-SOC profiles stored in the storage means 14 according to an embodiment of the present disclosure.

Referring to FIG. 3, at least one of the plurality of OCV-SOC profiles is an OCV-SOC profile of the battery 11 at Beginning Of Life (BOL) (see the solid line). Additionally, at least one other OCV-SOC profile is an OCV-SOC profile of the battery 11 at Middle Of Life (MOL) (10% reduction in capacity) (see the dashed line).

Although not shown, there may be two or more OCV-SOC profiles at MOL. For example, the storage means 14 may further store the OCV-SOC profile at MOL corresponding to 15% reduction in the capacity of the battery 11 and the OCV-SOC profile at MOL corresponding to 20% reduction in the capacity of the battery 11. It is obvious to those skilled in the art that the capacity reduction ratio corresponding to each MOL is not limited thereto.

Preferably, the plurality of OCV-SOC profiles may have the overlapping zone A in the preset SOC range. In the drawing, the overlapping zone is indicated by the rectangular box. The SOC range corresponding to the overlapping zone A may be about 65% to 100%. The location of the overlapping zone and the SOC range thereof may change depending on the types of positive and negative materials included in the battery 11.

It is very easy for those skilled in the art to select the type of the material such that the plurality of OCV-SOC profiles have the overlapping zone A. In an example, the positive electrode material may be lithium transition metal oxide including Ni, Co and Mn, and the negative electrode material may be graphite.

The overlapping zone A may have a change in location or width depending on the type or amount of the positive and/or negative electrode material. Additionally, the SOC range corresponding to the overlapping zone change in location or width.

The SOC range corresponding to the overlapping zone A may be set through the charge/discharge cycle test of the battery 11. The OCV-SOC profiles each corresponding to each of a plurality of capacity reduction ratios may be obtained through the charge/discharge cycle test of the battery 11. The obtained OCV-SOC profiles may be recorded in the storage means 14. For reference, the charge/discharge cycle test is a test for accurately measuring the capacity fading of the battery 11, and measuring the OCV according to the SOC of the battery 11.

The storage means 14 is not limited to a particular type and includes any type of storage means that can record and erase data and/or information. For example, the storage means 14 may be RAM, ROM, register, flash memory, hard disk, or a magnetic recording medium.

The storage means 14 may be electrically connected to the control means 16, for example, via a data bus to allow a control means 16 to access.

The storage means 14 stores and/or updates and/or erases and/or transmits programs including control logics executed by the control means 16 and/or data generated when the control logics are executed, and/or preset data, parameters, lookup information/tables or the like.

Referring back to FIG. 2, the apparatus 10 may include a measurement means 15. The measurement means 15 may periodically measure the voltage, current and temperature of the battery 11. The current may be a charge or discharge current.

Preferably, the measurement means 15 may include a voltage measurement unit 15a, a current measurement unit 15b and a temperature measurement unit 15c.

The voltage measurement unit 15a measures the voltage of the battery 11 at a predetermined time interval during the charging or discharging of the battery 11, and outputs the voltage measurement value to the control means 16.

The voltage measurement unit 15a may be a voltage measurement circuit known in the corresponding technical field. Since the voltage measurement circuit is well known, its detailed description is omitted.

The current measurement unit 15b measures a current flowing through the battery 11 at a predetermined time interval, and outputs the current measurement value to the control means 16.

The current measurement unit 15b may be a current measurement circuit known in the corresponding technical field. The current measurement unit 15b may be a hall effect sensor or a sense resistance that outputs the voltage value corresponding to the magnitude of the current. The voltage value may be converted to the current value by the Ohm's law.

The temperature measurement unit 15c measures the temperature of the battery 11 at a predetermined time interval during the charging or discharging of the battery 11 and outputs the temperature measurement value to the control means 16.

The temperature measurement unit 15c may be a temperature measurement circuit known in the corresponding technical field. The temperature measurement unit 15c may be a thermocouple or a temperature measurement device that outputs the voltage value corresponding to the temperature. The voltage value may be converted to the temperature value using the voltage-temperature conversion lookup table (function).

Additionally, the apparatus 10 may include the control means 16 operably coupled to the storage means 14 and the measurement means 15.

The control means 16 may control the charge or discharge of the battery based on the OCV-SOC profile corresponding to the degree of degradation of the battery 11. In an example, the control means 16 may charge the battery 11 to the upper limit voltage of the OCV-SOC profile, and discharge the battery 11 to the lower limit voltage of the OCV-SOC profile. In another example, after the battery 11 is kept in no-load condition for a predetermined time, the control means 16 may measure the OCV of the battery 11 using the voltage measurement unit 15a, and determine the SOC corresponding to the OCV by referring to the OCV-SOC profile.

Additionally, the control means 16 may calculate the partial capacity of the battery in the SOC range (for example, 65% to 100%) corresponding to the overlapping zone A during the charging or discharging of the battery 11. The partial capacity may be an increase in capacity when the battery 11 is charged from the lower limit to the upper limit of the SOC range corresponding to the overlapping zone A or a reduction in capacity when the battery 11 is discharged from the upper limit to the lower limit of the SOC range corresponding to the overlapping zone A. When the coulombic efficiency of the battery 11 is 1, the increase in capacity and the reduction in capacity are substantially equal.

The control means 16 may receive the current measurement value of the battery 11 from the current measurement unit 15b during the charging or discharging of the battery 11 in the SOC range corresponding to the overlapping zone A to calculate the partial capacity. Additionally, the control means 16 may calculate the partial capacity of the battery 11 in the SOC range of the overlapping zone A by accumulating the current measurement value using the current accumulation method. When accumulating the current measurement value, the sum of charge currents is a plus value, and the sum of discharge currents is a minus value.

The control means 16 may determine the capacity of the battery 11 and record it in the storage means 14 to determine the SOC of the battery 11 during the charging or discharging of the battery 11. That is, the control means 16 may determine the capacity of the battery 11 by accumulating the current of the battery 11 measured by the current measurement unit 15b during the charging of the battery 11 from the lower limit to the upper limit of the OCV range of the current OCV-SOC profile or during the discharging of the battery 11 from the upper limit to the lower limit of the OCV range of the current OCV-SOC profile and record it in the storage means 14.

Additionally, the control means 16 may determine the current SOC by accumulating the current of the battery 11 on the basis of the current capacity during the charging or discharging of the battery 11. Specifically, the control means 16 may measure the OCV when the battery 11 is in no-load condition, determine the SOC corresponding to the measured OCV by referring to the current OCV-SOC profile, determine the determined SOC as an initial SOC value, and then when the battery 11 starts charging or discharging, periodically update the cumulative current value, determine an SOC change by dividing the cumulative current value calculated until the present time by the current capacity of the battery 11, and determine the current SOC by adding the SOC change to the initial SOC value. This SOC determination method is well known in the corresponding technical art in the name of the current accumulation method.

In another example, the control means 16 may determine the SOC of the battery 11 using an extended Kalman filter. To this end, the control means 16 may determine the SOC of the battery 11 in real time by inputting the operational characteristics value of the battery 11 measured through the voltage measurement unit 15a, the current measurement unit 15b and the temperature measurement unit 15c to the extended Kalman filter during the charging or discharging of the battery 11. Here, the operational characteristics value includes the measurement value of the voltage, current and temperature of the battery 11.

The extended Kalman filter used to determine the SOC from the voltage, current and temperature of the battery 11 is well known in the corresponding technical field.

For the SOC estimation using the extended Kalman filter, for example, reference may be made to Gregory L. Plett's paper "Extended Kalman filtering for battery management systems of LiPB-based HEV battery packs Parts 1, 2 and 3"(Journal of Power Source 134, 2004, 252-261), the disclosure of which is incorporated herein by reference.

Preferably, the control means 16 may determine a first cumulative current amount until the SOC of the battery 11 corresponds to the lower limit of the SOC range of the overlapping zone A. Additionally, the control means 16 may determine a second cumulative current amount until the SOC of the battery 11 corresponds to the upper limit of the SOC range of the overlapping zone A. Additionally, the control means 16 may determine a difference between the first cumulative current amount and the second cumulative current amount as the partial capacity corresponding to the SOC range of the overlapping zone A.

Preferably, the control means 16 may determine a reduction ratio of the current partial capacity to the partial capacity of the battery 11 at BOL.

In an example, when the partial capacity of the battery 11 at BOL calculated in the SOC range (65% to 100%) of the overlapping zone A is 35Ah, and the partial capacity of the battery 11 at MOL calculated in the SOC range of the overlapping zone A is 31.5A, the reduction ratio of the partial capacity may be 10% (3.5/35).

In another example, when the partial capacity of the battery 11 at BOL calculated in the SOC range (65% to 100%) of the overlapping zone A is 35Ah, and the partial capacity of the battery 11 at MOL calculated in the SOC range of the overlapping zone A is 28Ah, the reduction ratio of the partial capacity may be 20% (7/35).

Preferably, when the coulombic efficiency of the battery 11 is not 1, the partial capacity calculation criteria may be equally applied. That is, in case where the partial capacity at BOL is measured during the charging of the battery 11, the partial capacity at MOL may be measured during the charging of the battery 11. On the contrary, in case where the partial capacity at BOL is measured during the discharging of the battery 11, the partial capacity at MOL may be measured during the discharging of the battery 11.

Additionally, when the reduction ratio satisfies the change condition of the OCV-SOC profile, the control means 16 may select the OCV-SOC profile corresponding to the reduction ratio among the plurality of OCV-SOC profiles recorded in the storage means 14, change the current OCV-SOC profile to the selected OCV-SOC profile and control the charge or discharge of the battery 11 using the changed OCV-SOC profile, or may measure the OCV of the battery 11 and estimate the SOC from the selected OCV-SOC profile.

In an example, when the reduction ratio corresponds to a preset first threshold (for example, 10%), the control means 16 may select the OCV-SOC profile corresponding to the first threshold among the plurality of OCV-SOC profiles, change the current OCV-SOC profile to the selected OCV-SOC profile and control the charge or discharge of the battery 11 using the changed OCV-SOC profile, or may measure the OCV of the battery 11 and estimate the SOC from the selected OCV-SOC profile.

In another example, when the reduction ratio corresponds to a preset second threshold (larger than the first threshold, for example, 20%), the control means 16 may select the OCV-SOC profile corresponding to the second threshold among the plurality of OCV-SOC profiles, change the current OCV-SOC profile to the selected OCV-SOC profile and control the charge or discharge of the battery 11 using the changed OCV-SOC profile, or may measure the OCV of the battery 11 and estimate the SOC from the selected OCV-SOC profile.

In the present disclosure, the threshold is not limited to only the first threshold and the second threshold. Accordingly, three or more thresholds may be set. In this case, the OCV-SOC profiles recorded in the storage means 14 may be sub-classified according to the reduction ratio of the partial capacity.

Preferably, the plurality of OCV-SOC profiles may be recorded in the storage means 14 in the format of data structure so as to identify the corresponding OCV-SOC profile according to the reduction ratio of the partial capacity.

In an example, each OCV-SOC profile may be generated with a structure of a lookup table and recorded in the storage means 14. Additionally, each lookup table may be allocated with identification code to identify by the reduction ratio of the partial capacity. In this case, the control means 16 may identify and select the corresponding lookup table by referring to the reduction ratio of the partial capacity calculated in the SOC range of the overlapping zone A, generate the OCV-SOC profile by referring to the identified lookup table, and control the charge or discharge of the battery 11 using the generated OCV-SOC profile.

In the present disclosure, the control logic used to select the lookup table according to the partial capacity reduction ratio of the battery 11 is substantially the same as the control logic used to select the OCV-SOC profile according to the partial capacity reduction ratio of the battery 11.

In the present disclosure, the control means 16 may be a control circuit. The control means 16 may selectively include a processor, an application-specific integrated circuit (ASIC), a chipset, a logic circuit, register, a communication modem, a data processing device or the like, known in the corresponding technical field to execute the above-described control logics. Additionally, when the control logic are implemented in software, the control means 16 may be designed as a collection of program modules. In this instance, the program modules may be stored in memory and executed by the processor. The memory may be inside or outside of the processor, and may be connected to the processor with a variety of known computer components. Additionally, the memory may be included in the storage means 14 of the present disclosure. Additionally, the memory refers collectively to devices that store information irrespective of device type and does not refer to a particular memory device.

At least one of the control logics of the control means 16 may be combined together, and the combined control logics may be written in computer-readable code and recorded in computer-readable recording medium. The recording medium is not limited to a particular type and includes any type of recording medium that can be accessed by the processor included in the computer. For example, the recording medium includes at least one selected from the group consisting of ROM, RAM, register, CD-ROM, magnetic tape, hard disk, floppy disk and an optical data recording device. Additionally, the code may be stored and executed in distributed computers connected via a network. Additionally, the functional programs, code and code segments for implementing the combined control logics can be easily inferred by programmers in the technical field pertaining to the present disclosure.

The apparatus 10 according to the above-described embodiment of the present disclosure may be included in an Energy Storage System (ESS), an electric vehicle system or an uninterruptible power supply system. In addition, the apparatus 10 may be included in any system that is supplied with power from the battery 11. The apparatus 10 is preferably incorporated in a control element of the system including it. The apparatus 10 may calculate the partial capacity during the charging or discharging of the battery of the system including it in the SOC range of the overlapping zone A, determine the reduction ratio of the partial capacity calculated at the present time to the partial capacity of the battery at BOL, and when the reduction ratio reaches the threshold, change the OCV-SOC profile referenced when controlling the charge/discharge of the battery to the more appropriate profile reflecting the degree of degradation of the battery. Accordingly, it is possible to optimally control the charge/discharge of the battery according to the degree of degradation of the battery.

In the present disclosure, the electric vehicle refers to a vehicle that operates by a motor, such as an electric vehicle, a hybrid electric vehicle and a plugin hybrid electric vehicle. The vehicle may be a two-, three- or four-wheeled vehicle.

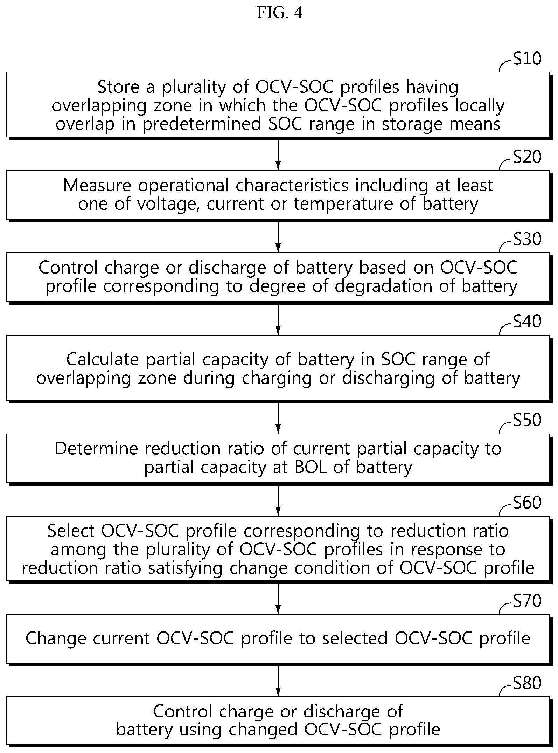

FIG. 4 is a flowchart showing the workflow of a method for managing an OCV-SOC profile of a battery according to an embodiment of the present disclosure.

In the flowchart, earlier steps are not necessarily performed prior to later steps. The earlier steps and later steps may be exchanged, and a specific step may move before or after other step. Accordingly, it should be understood that the present disclosure is not limited to the order of placement of the steps.

Preferably, the steps shown in FIG. 4 may be performed by the control means 16.

To begin with, in step S10, the control means 16 stores the plurality of OCV-SOC profiles having the overlapping zone (see A in FIG. 3) in which the OCV-SOC profiles locally overlap in the predetermined SOC range in the storage means 14. The plurality of OCV-SOC profiles may be provided from the manufacturer of the battery 11. The control means 16 may receive the plurality of OCV-SOC profiles from the system of the battery manufacturer through an I/O interface (not shown) or a communication interface (not shown) and record it in the storage means 14. Preferably, the plurality of OCV-SOC profiles may be stored in the form of a lookup table, and each lookup table may be allocated with identification code to uniquely identify according to the reduction ratio of the partial capacity.

Additionally, in step S20, the control means 16 measures operational characteristics including at least one of the voltage, current or temperature of the battery. Additionally, the control means 16 may record data associated with the operational characteristics in the storage means 14 together with a time stamp. The operational characteristics data may be used to estimate the SOC of the battery 11 and calculate the partial capacity.

Additionally, in step S30, the control means 16 may control the charge or discharge of the battery based on the current OCV-SOC profile corresponding to the degree of degradation of the battery.

In an example, when the battery 11 is at BOL, the current OCV-SOC profile may be a profile at BOL. In another example, when the battery 11 is at MOL, the current OCV-SOC profile may be a profile at MOL.

Preferably, the current OCV-SOC profile may be changed to other OCV-SOC profile according to the reduction ratio of the partial capacity in the subsequent step.

In step S40, the control means 16 calculates the partial capacity of the battery 11 in the preset SOC range of the overlapping zone A during the charging or discharging of the battery 11.

Preferably, the control means 16 may calculate the partial capacity of the battery 11 by accumulating the current measurement value of the battery 11 in the SOC range of the overlapping zone A.

In an example, in step S40, the control means 16 may determine the current capacity of the battery by accumulating the current measurement value of the battery during the charging or discharging of the battery 11 in the OCV range of the current OCV-SOC profile, determine the SOC of the battery by accumulating the charge current and discharge current of the battery on the basis of the current capacity, determine the first cumulative current amount until the SOC corresponds to the lower limit of the SOC range of the overlapping zone A, determine the second cumulative current amount until the SOC corresponds to the upper limit of the SOC range of the overlapping zone A, and determine a difference between the first cumulative current amount and the second cumulative current amount as the partial capacity.

Preferably, the current capacity of the battery 11 may be pre-determined in the charge/discharge cycle of the battery 11 before calculating the partial capacity and recorded in the storage means 14. Additionally, reference may be made to the current capacity of the battery 11 recorded in the storage means 14 when determining the SOC of the battery 11.

The step S40 is followed by step S50.

In the step S50, the control means 16 determines the reduction ratio of the current partial capacity to the partial capacity of the battery 11 at BOL.

In step S60, when the reduction ratio of the partial capacity satisfies the change condition of the OCV-SOC profile, the control means 16 selects the OCV-SOC profile corresponding to the reduction ratio among the plurality of OCV-SOC profiles recorded in the storage means 14.

In step S70, the control means 16 changes the OCV-SOC profile referenced until the present time to the selected OCV-SOC profile. Additionally, in step S80, the control means 16 controls the charge or discharge of the battery using the changed OCV-SOC profile. Optionally, in the step 80, the control means 16 may estimate the SOC of the battery 11 using the selected OCV-SOC profile.

That is, when the battery 11 is in no-load condition, the control means 16 may measure the OCV of the battery 11 using the voltage measurement unit 15a, determine the SOC corresponding to the measured OCV by referring to the selected OCV-SOC profile, and set the determined SOC as an SOC (initial value) before the charge or discharge of the battery 11. In this case, the control means 16 may accumulate the current measurement value during the charging or discharging of the battery 11 and determine the current SOC of the battery 11 by summing the initial SOC value determined from the OCV and the SOC change corresponding to the cumulative current value until the present time.

According to the specific embodiment of the steps S60 to S80, when the reduction ratio of the partial capacity corresponds to the preset first threshold (for example, 10%), the control means 16 may select the OCV-SOC profile corresponding to the first threshold among the plurality of OCV-SOC profiles recorded in the storage means 14, change the OCV-SOC profile referenced until the present time to the selected OCV-SOC profile, and control the charge or discharge of the battery 11 or estimate the SOC of the battery 11 using the changed OCV-SOC profile.

In another example, when the reduction ratio of the partial capacity corresponds to the preset second threshold (larger than the first threshold, for example, 20%), the control means 16 may select the OCV-SOC profile corresponding to the second threshold among the plurality of OCV-SOC profiles recorded in the storage means 14, change the OCV-SOC profile referenced until the present time to the selected OCV-SOC profile, and control the charge or discharge of the battery 11 or estimate the SOC of the battery 11 using the changed OCV-SOC profile.

In the present disclosure, the level of the threshold is not limited to only the first threshold and the second threshold and thus three or more thresholds may be set, and when the level of the threshold increases to 3 or more, it is obvious to those skilled in the art that the OCV-SOC profile recorded in the storage means 134 may increase to 3 or more.

According to the above-described embodiment of the present disclosure, when changing the OCV-SOC profile according to the degree of degradation of the battery, it is possible to solve the repeated switching problem of the OCV-SOC profile by newly changing the profile change criteria. Accordingly, it is possible to optimally control the charge/discharge of the battery according to the degree of degradation of the battery.

In describing the various embodiments of the present disclosure, the components called '~ means' should be understood as components that are functionally divided rather than physically. Accordingly, each component may be selectively combined with other component or split into subcomponents for the efficient execution of the control logic(s). However, it is obvious to those skilled in the art that even though the components are combined or split, the combined or split components should be interpreted as falling within the scope of the present disclosure in case that the identity of function is acknowledged.

## Claims

1. An apparatus (10) for managing an Open Circuit Voltage, OCV,-State Of Charge, SOC, profile of a battery (11), comprising:
a storage means (14) configured to store a plurality of OCV-SOC profiles having an overlapping zone in which the OCV-SOC profiles overlap in a predetermined SOC range;
a measurement means (15) configured to measure operational characteristics including at least one of voltage, current or temperature of the battery (11); and
a control means (16) operably coupled to the storage means (14) and the measurement means (15),
wherein the control means (16) is configured to:
control charge or discharge of the battery (11) based on the OCV-SOC profile corresponding to a degree of degradation of the battery, calculate a partial capacity of the battery (11) in the SOC range of the overlapping zone during charging or discharging of the battery (11), determine a reduction ratio of the current partial capacity to the partial capacity of the battery (11) at Beginning Of Life, BOL, in response to the reduction ratio satisfying a change condition of the OCV-SOC profile, select the OCV-SOC profile corresponding to the reduction ratio among the plurality of OCV-SOC profiles, change the current OCV-SOC profile to the selected OCV-SOC profile, and control the charge or discharge of the battery (11) using the changed OCV-SOC profile,
wherein the partial capacity may be an increase in capacity when the battery (11) is charged from the lower limit to the upper limit of the SOC range corresponding to the overlapping zone or a reduction in capacity when the battery (11) is discharged from the upper limit to the lower limit of the SOC range corresponding to the overlapping zone,
wherein the control means (16) is configured to:
select the OCV-SOC profile corresponding to a preset first threshold among the plurality of OCV-SOC profiles in response to the reduction ratio corresponding to the first threshold,
change the OCV-SOC profile referenced until the present time to the selected OCV-SOC profile, and control the charge or discharge of the battery (11) using the changed OCV-SOC profile; and
select the OCV-SOC profile corresponding to a preset second threshold among the plurality of OCV-SOC profiles in response to the reduction ratio corresponding to the second threshold, larger than the first threshold.

2. The apparatus (10) for managing an OCV-SOC profile of a battery (11) according to claim 1, wherein the control means (16) is configured to receive the current measurement value of the battery (11) from the measurement means (15), and calculate the partial capacity of the battery (11) in the SOC range of the overlapping zone using a current accumulation method.

3. The apparatus for managing an OCV-SOC profile of a battery (11) according to claim 1, wherein the control means is configured to receive the current measurement value of the battery (11) from the measurement means during the charging or discharging of the battery (11) in the OCV range of the current OCV-SOC profile, determine the current capacity of the battery (11) using a current accumulation method, record it in the storage means, and determine the current SOC by accumulating the current of the battery (11) based on the current capacity.

4. The apparatus for managing an OCV-SOC profile of a battery (11) according to claim 3, wherein the control means is configured to determine a first cumulative current amount when the SOC corresponds to a lower limit of the SOC range of the overlapping zone, determine a second cumulative current amount when the SOC corresponds to an upper limit of the SOC range of the overlapping zone, and determine a difference between the first cumulative current amount and the second cumulative current amount as the partial capacity.

5. A system comprising the apparatus (10) for managing an OCV-SOC profile of a battery (11) according to any one of claims 1 to 4.

6. An electric vehicle comprising the apparatus (10) for managing an OCV-SOC profile of a battery (11) according to any one of claims 1 to 4.

7. A method for managing an Open Circuit Voltage, OCV,-State Of Charge, SOC, profile of a battery, comprising:
(a) storing (S10) a plurality of OCV-SOC profiles having an overlapping zone in which the OCV-SOC profiles overlap in a predetermined SOC range in a storage means;
(b) measuring (S20) operational characteristics including at least one of voltage, current or temperature of the battery;
(c) controlling (S30) charge or discharge of the battery based on the OCV-SOC profile corresponding to a degree of degradation of the battery;
(d) calculating (S40) a partial capacity of the battery in the SOC range of the overlapping zone during charging or discharging of the battery;
(e) determining (S50) a reduction ratio of the current partial capacity to the partial capacity of the battery at Beginning Of Life, BOL;
(f) selecting (S60) the OCV-SOC profile corresponding to the reduction ratio among the plurality of OCV-SOC profiles in response to the reduction ratio satisfying a change condition of the OCV-SOC profile; and
(g) changing (S70) the current OCV-SOC profile to the selected OCV-SOC profile, and controlling the charge or discharge of the battery using the changed OCV-SOC profile, wherein the partial capacity may be an increase in capacity when the battery is charged from the lower limit to the upper limit of the SOC range corresponding to the overlapping zone or a reduction in capacity when the battery is discharged from the upper limit to the lower limit of the SOC range corresponding to the overlapping zone,
wherein step (f) (S60) comprises:
selecting the OCV-SOC profile corresponding to a preset first threshold among the plurality of OCV-SOC profiles in response to the reduction ratio corresponding to the first threshold, wherein step (f) (S60) comprises:
selecting the OCV-SOC profile corresponding to a preset second threshold among the plurality of OCV-SOC profiles in response to the reduction ratio corresponding to the second threshold (larger than the first threshold)
wherein step (g) (S70) comprises changing the OCV-SOC profile referenced until the present time to the selected OCV-SOC profile, and controlling the charge or discharge of the battery using the changed OCV-SOC profile.

8. The method for managing an OCV-SOC profile of a battery according to claim 7, wherein step (d) comprises calculating the partial capacity of the battery by accumulating the current measurement value of the battery in the SOC range of the overlapping zone.

9. The method for managing an OCV-SOC profile of a battery according to claim 7, further comprising:
determining the current capacity of the battery by accumulating the current measurement value of the battery during the charging or discharging of the battery in the OCV range of the current OCV-SOC profile; and
determining the SOC of the battery by accumulating the current of the battery on the basis of the current capacity.

10. The method for managing an OCV-SOC profile of a battery according to claim 9, wherein step (d) comprises:
determining a first cumulative current amount until the SOC corresponds to a lower limit of the SOC range of the overlapping zone;
determining a second cumulative current amount until the SOC corresponds to an upper limit of the SOC range of the overlapping zone; and
determining a difference between the first cumulative current amount and the second cumulative current amount as the partial capacity.

## Patentansprüche

1. Vorrichtung (10) zur Verwaltung eines Leerlaufspannungs, OCV,-Ladezustands, SOC,-Profils einer Batterie (11), umfassend:
ein Speichermittel (14), das konfiguriert ist, um eine Vielzahl von OCV-SOC-Profilen mit einer Überlappungszone zu speichern, in der sich die OCV-SOC-Profile in einem vorbestimmten SOC-Bereich überlappen;
ein Messmittel (15), das konfiguriert ist, um Betriebsmerkmale zu messen, die mindestens eines von Spannung, Strom oder Temperatur der Batterie (11) einschließen; und
ein Steuerungsmittel (16), das betriebsfähig mit dem Speichermittel (14) und dem Messmittel (15) gekoppelt ist,
wobei das Steuerungsmittel (16) konfiguriert ist zum:
Steuern des Ladens oder Entladens der Batterie (11) basierend auf dem OCV-SOC-Profil, das einem Abbaugrad der Batterie entspricht, Berechnen einer Teilkapazität der Batterie (11) im SOC-Bereich der Überlappungszone während des Ladens oder Entladens der Batterie (11), Bestimmen eines Reduktionsverhältnisses der aktuellen Teilkapazität zur Teilkapazität der Batterie (11) am Anfang der Lebensdauer, BOL, als Reaktion darauf, dass das Reduktionsverhältnis eine Änderungsbedingung des OCV-SOC-Profils erfüllt, Auswählen des OCV-SOC-Profils, das dem Reduktionsverhältnis entspricht, aus der Vielzahl von OCV-SOC-Profilen, Ändern des aktuellen OCV-SOC-Profils in das ausgewählte OCV-SOC-Profil und Steuern des Ladens oder Entladens der Batterie (11) unter Verwendung des geänderten OCV-SOC-Profils,
wobei die Teilkapazität eine Kapazitätszunahme sein kann, wenn die Batterie (11) von der unteren Grenze bis zur oberen Grenze des SOC-Bereichs, der der Überlappungszone entspricht, geladen wird, oder eine Kapazitätsabnahme, wenn die Batterie (11) von der oberen Grenze bis zur unteren Grenze des SOC-Bereichs, der der Überlappungszone entspricht, entladen wird,
wobei das Steuerungsmittel (16) konfiguriert ist zum:
Auswählen des OCV-SOC-Profils, das einem voreingestellten ersten Schwellenwert entspricht, aus der Vielzahl von OCV-SOC-Profilen als Reaktion darauf, dass das Reduktionsverhältnis dem ersten Schwellenwert entspricht,
Ändern des bis zum gegenwärtigen Zeitpunkt referenzierten OCV-SOC-Profils in das ausgewählte OCV-SOC-Profil und Steuern des Ladens oder Entladens der Batterie (11) unter Verwendung des geänderten OCV-SOC-Profils; und
Auswählen des OCV-SOC-Profils, das einem voreingestellten zweiten Schwellenwert entspricht, aus der Vielzahl von OCV-SOC-Profilen als Reaktion darauf, dass das Reduktionsverhältnis dem zweiten Schwellenwert entspricht, der größer als der erste Schwellenwert ist.

2. Vorrichtung (10) zur Verwaltung eines OCV-SOC-Profils einer Batterie (11) nach Anspruch 1, wobei das Steuerungsmittel (16) konfiguriert ist, um den Strommesswert der Batterie (11) vom Messmittel (15) zu empfangen und die Teilkapazität der Batterie (11) im SOC-Bereich der Überlappungszone unter Verwendung eines Stromakkumulationsverfahrens zu berechnen.

3. Vorrichtung zur Verwaltung eines OCV-SOC-Profils einer Batterie (11) nach Anspruch 1, wobei das Steuerungsmittel konfiguriert ist, um den Strommesswert der Batterie (11) vom Messmittel während des Ladens oder Entladens der Batterie (11) im OCV-Bereich des aktuellen OCV-SOC-Profils zu empfangen, die aktuelle Kapazität der Batterie (11) unter Verwendung eines Stromakkumulationsverfahrens zu bestimmen, sie im Speichermittel aufzuzeichnen und den aktuellen SOC durch Akkumulieren des Stroms der Batterie (11) basierend auf der aktuellen Kapazität zu bestimmen.

4. Vorrichtung zur Verwaltung eines OCV-SOC-Profils einer Batterie (11) nach Anspruch 3, wobei das Steuerungsmittel konfiguriert ist, um einen ersten kumulativen Strombetrag zu bestimmen, wenn der SOC einer unteren Grenze des SOC-Bereichs der Überlappungszone entspricht, einen zweiten kumulativen Strombetrag zu bestimmen, wenn der SOC einer oberen Grenze des SOC-Bereichs der Überlappungszone entspricht, und eine Differenz zwischen dem ersten kumulativen Strombetrag und dem zweiten kumulativen Strombetrag als Teilkapazität zu bestimmen.

5. System, umfassend die Vorrichtung (10) zur Verwaltung eines OCV-SOC-Profils einer Batterie (11) nach einem der Ansprüche 1 bis 4.

6. Elektrofahrzeug, umfassend die Vorrichtung (10) zur Verwaltung eines OCV-SOC-Profils einer Batterie (11) nach einem der Ansprüche 1 bis 4.

7. Verfahren zur Verwaltung eines Leerlaufspannungs, OCV,-Ladezustands, SOC,-Profils einer Batterie, umfassend:
(a) Speichern (S10) einer Vielzahl von OCV-SOC-Profilen mit einer Überlappungszone, in der sich die OCV-SOC-Profile in einem vorbestimmten SOC-Bereich überlappen, in einem Speichermittel;
(b) Messen (S20) von Betriebsmerkmalen, die mindestens eines von Spannung, Strom oder Temperatur der Batterie einschließen;
(c) Steuern (S30) des Ladens oder Entladens der Batterie basierend auf dem OCV-SOC-Profil, das einem Abbaugrad der Batterie entspricht;
(d) Berechnen (S40) einer Teilkapazität der Batterie im SOC-Bereich der Überlappungszone während des Ladens oder Entladens der Batterie;
(e) Bestimmen (S50) eines Reduktionsverhältnisses der aktuellen Teilkapazität zur Teilkapazität der Batterie am Anfang der Lebensdauer, BOL;
(f) Auswählen (S60) des OCV-SOC-Profils, das dem Reduktionsverhältnis entspricht, aus der Vielzahl von OCV-SOC-Profilen als Reaktion darauf, dass das Reduktionsverhältnis eine Änderungsbedingung des OCV-SOC-Profils erfüllt; und
(g) Ändern (S70) des aktuellen OCV-SOC-Profils in das ausgewählte OCV-SOC-Profil und Steuern des Ladens oder Entladens der Batterie unter Verwendung des geänderten OCV-SOC-Profils,
wobei die Teilkapazität eine Kapazitätszunahme sein kann, wenn die Batterie von der unteren Grenze bis zur oberen Grenze des SOC-Bereichs, der der Überlappungszone entspricht, geladen wird, oder eine Kapazitätsabnahme, wenn die Batterie von der oberen Grenze bis zur unteren Grenze des SOC-Bereichs, der der Überlappungszone entspricht, entladen wird,
wobei Schritt (f) (S60) umfasst:
Auswählen des OCV-SOC-Profils, das einem voreingestellten ersten Schwellenwert entspricht, aus der Vielzahl von OCV-SOC-Profilen als Reaktion darauf, dass das Reduktionsverhältnis dem ersten Schwellenwert entspricht,
wobei Schritt (f) (S60) umfasst:
Auswählen des OCV-SOC-Profils, das einem voreingestellten zweiten Schwellenwert entspricht, aus der Vielzahl von OCV-SOC-Profilen als Reaktion darauf, dass das Reduktionsverhältnis dem zweiten Schwellenwert (größer als der erste Schwellenwert) entspricht,
wobei Schritt (g) (S70) das Ändern des bis zum gegenwärtigen Zeitpunkt referenzierten OCV-SOC-Profils in das ausgewählte OCV-SOC-Profil und das Steuern des Ladens oder Entladens der Batterie unter Verwendung des geänderten OCV-SOC-Profils umfasst.

8. Verfahren zur Verwaltung eines OCV-SOC-Profils einer Batterie nach Anspruch 7, wobei Schritt (d) das Berechnen der Teilkapazität der Batterie durch Akkumulieren des Strommesswerts der Batterie im SOC-Bereich der Überlappungszone umfasst.

9. Verfahren zur Verwaltung eines OCV-SOC-Profils einer Batterie nach Anspruch 7, ferner umfassend:
Bestimmen der aktuellen Kapazität der Batterie durch Akkumulieren des Strommesswerts der Batterie während des Ladens oder Entladens der Batterie im OCV-Bereich des aktuellen OCV-SOC-Profils; und
Bestimmen des SOC der Batterie durch Akkumulieren des Stroms der Batterie auf der Grundlage der aktuellen Kapazität.

10. Verfahren zur Verwaltung eines OCV-SOC-Profils einer Batterie nach Anspruch 9, wobei Schritt (d) umfasst:
Bestimmen eines ersten kumulativen Strombetrags, bis der SOC einer unteren Grenze des SOC-Bereichs der Überlappungszone entspricht;
Bestimmen eines zweiten kumulativen Strombetrags, bis der SOC einer oberen Grenze des SOC-Bereichs der Überlappungszone entspricht; und
Bestimmen einer Differenz zwischen dem ersten kumulativen Strombetrag und dem zweiten kumulativen Strombetrag als Teilkapazität.

## Revendications

1. Appareil (10) de gestion d'un profil de Tension en Circuit Ouvert, OCV, - État de Charge, SOC, d'une batterie (11), comprenant :
un moyen de stockage (14) configuré pour stocker une pluralité de profils OCV-SOC ayant une zone de chevauchement dans laquelle les profils OCV-SOC se chevauchent dans une plage de SOC prédéterminée ;
un moyen de mesure (15) configuré pour mesurer des caractéristiques de fonctionnement incluant au moins l'un parmi la tension, le courant ou la température de la batterie (11) ; et
un moyen de commande (16) couplé de manière opérationnelle au moyen de stockage (14) et au moyen de mesure (15),
dans lequel le moyen de commande (16) est configuré pour :
commander la charge ou la décharge de la batterie (11) sur la base du profil OCV-SOC correspondant à un degré de dégradation de la batterie, calculer une capacité partielle de la batterie (11) dans la plage de SOC de la zone de chevauchement pendant la charge ou la décharge de la batterie (11), déterminer un rapport de réduction de la capacité partielle actuelle par rapport à la capacité partielle de la batterie (11) au Début de Vie, BOL, en réponse au fait que le rapport de réduction satisfait une condition de changement du profil OCV-SOC, sélectionner le profil OCV-SOC correspondant au rapport de réduction parmi la pluralité de profils OCV-SOC, changer le profil OCV-SOC actuel pour le profil OCV-SOC sélectionné, et commander la charge ou la décharge de la batterie (11) en utilisant le profil OCV-SOC changé,
dans lequel la capacité partielle peut être une augmentation de capacité lorsque la batterie (11) est chargée de la limite inférieure à la limite supérieure de la plage de SOC correspondant à la zone de chevauchement ou une réduction de capacité lorsque la batterie (11) est déchargée de la limite supérieure à la limite inférieure de la plage de SOC correspondant à la zone de chevauchement,
dans lequel le moyen de commande (16) est configuré pour :
sélectionner le profil OCV-SOC correspondant à un premier seuil prédéfini parmi la pluralité de profils OCV-SOC en réponse au rapport de réduction correspondant au premier seuil,
changer le profil OCV-SOC référencé jusqu'au moment présent pour le profil OCV-SOC sélectionné, et commander la charge ou la décharge de la batterie (11) en utilisant le profil OCV-SOC changé ; et
sélectionner le profil OCV-SOC correspondant à un second seuil prédéfini parmi la pluralité de profils OCV-SOC en réponse au rapport de réduction correspondant au second seuil, plus grand que le premier seuil.

2. L'appareil (10) de gestion d'un profil OCV-SOC d'une batterie (11) selon la revendication 1, dans lequel le moyen de commande (16) est configuré pour recevoir la valeur de mesure de courant de la batterie (11) depuis le moyen de mesure (15), et calculer la capacité partielle de la batterie (11) dans la plage de SOC de la zone de chevauchement en utilisant un procédé d'accumulation de courant.

3. L'appareil de gestion d'un profil OCV-SOC d'une batterie (11) selon la revendication 1, dans lequel le moyen de commande est configuré pour recevoir la valeur de mesure de courant de la batterie (11) depuis le moyen de mesure pendant la charge ou la décharge de la batterie (11) dans la plage OCV du profil OCV-SOC actuel, déterminer la capacité actuelle de la batterie (11) en utilisant un procédé d'accumulation de courant, l'enregistrer dans le moyen de stockage, et déterminer le SOC actuel en accumulant le courant de la batterie (11) sur la base de la capacité actuelle.

4. L'appareil de gestion d'un profil OCV-SOC d'une batterie (11) selon la revendication 3, dans lequel le moyen de commande est configuré pour déterminer une première quantité de courant cumulée lorsque le SOC correspond à une limite inférieure de la plage de SOC de la zone de chevauchement, déterminer une seconde quantité de courant cumulée lorsque le SOC correspond à une limite supérieure de la plage de SOC de la zone de chevauchement, et déterminer une différence entre la première quantité de courant cumulée et la seconde quantité de courant cumulée comme étant la capacité partielle.

5. Un système comprenant l'appareil (10) de gestion d'un profil OCV-SOC d'une batterie (11) selon l'une quelconque des revendications 1 à 4.

6. Un véhicule électrique comprenant l'appareil (10) de gestion d'un profil OCV-SOC d'une batterie (11) selon l'une quelconque des revendications 1 à 4.

7. Un procédé de gestion d'un profil de Tension en Circuit Ouvert, OCV, - État de Charge, SOC, d'une batterie, comprenant :
(a) le stockage (S10) d'une pluralité de profils OCV-SOC ayant une zone de chevauchement dans laquelle les profils OCV-SOC se chevauchent dans une plage de SOC prédéterminée dans un moyen de stockage ;
(b) la mesure (S20) de caractéristiques de fonctionnement incluant au moins l'un parmi la tension, le courant ou la température de la batterie ;
(c) la commande (S30) de la charge ou de la décharge de la batterie sur la base du profil OCV-SOC correspondant à un degré de dégradation de la batterie ;
(d) le calcul (S40) d'une capacité partielle de la batterie dans la plage de SOC de la zone de chevauchement pendant la charge ou la décharge de la batterie ;
(e) la détermination (S50) d'un rapport de réduction de la capacité partielle actuelle par rapport à la capacité partielle de la batterie au Début de Vie, BOL ;
(f) la sélection (S60) du profil OCV-SOC correspondant au rapport de réduction parmi la pluralité de profils OCV-SOC en réponse au fait que le rapport de réduction satisfait une condition de changement du profil OCV-SOC ; et
(g) le changement (S70) du profil OCV-SOC actuel pour le profil OCV-SOC sélectionné, et la commande de la charge ou de la décharge de la batterie en utilisant le profil OCV-SOC changé,
dans lequel la capacité partielle peut être une augmentation de capacité lorsque la batterie est chargée de la limite inférieure à la limite supérieure de la plage de SOC correspondant à la zone de chevauchement ou une réduction de capacité lorsque la batterie est déchargée de la limite supérieure à la limite inférieure de la plage de SOC correspondant à la zone de chevauchement,
dans lequel l'étape (f) (S60) comprend :
la sélection du profil OCV-SOC correspondant à un premier seuil prédéfini parmi la pluralité de profils OCV-SOC en réponse au rapport de réduction correspondant au premier seuil,
dans lequel l'étape (f) (S60) comprend :
la sélection du profil OCV-SOC correspondant à un second seuil prédéfini parmi la pluralité de profils OCV-SOC en réponse au rapport de réduction correspondant au second seuil (plus grand que le premier seuil)
dans lequel l'étape (g) (S70) comprend le changement du profil OCV-SOC référencé jusqu'au moment présent pour le profil OCV-SOC sélectionné, et la commande de la charge ou de la décharge de la batterie en utilisant le profil OCV-SOC changé.

8. Le procédé de gestion d'un profil OCV-SOC d'une batterie selon la revendication 7, dans lequel l'étape (d) comprend le calcul de la capacité partielle de la batterie en accumulant la valeur de mesure de courant de la batterie dans la plage de SOC de la zone de chevauchement.

9. Le procédé de gestion d'un profil OCV-SOC d'une batterie selon la revendication 7, comprenant en outre :
la détermination de la capacité actuelle de la batterie en accumulant la valeur de mesure de courant de la batterie pendant la charge ou la décharge de la batterie dans la plage OCV du profil OCV-SOC actuel ; et
la détermination du SOC de la batterie en accumulant le courant de la batterie sur la base de la capacité actuelle.

10. Le procédé de gestion d'un profil OCV-SOC d'une batterie selon la revendication 9, dans lequel l'étape (d) comprend :
la détermination d'une première quantité de courant cumulée jusqu'à ce que le SOC corresponde à une limite inférieure de la plage de SOC de la zone de chevauchement ;
la détermination d'une seconde quantité de courant cumulée jusqu'à ce que le SOC corresponde à une limite supérieure de la plage de SOC de la zone de chevauchement ; et
la détermination d'une différence entre la première quantité de courant cumulée et la seconde quantité de courant cumulée comme étant la capacité partielle.
